# EUROPEAN PATENT APPLICATION

(11) **EP 4 345 868 A2**
(43) Date of publication of application: **03.04.2024**
(21) Application number: 23187406.6
(22) Date of filing: 25.07.2023
(51) Int. Cl.: H01L 21/768, H01L 23/532

(54) **INTEGRATED CIRCUIT INTERCONNECT STRUCTURES WITH NIOBIUM BARRIER MATERIALS**

(30) Priority: 30.09.2022 US 202217957721
(71) Applicant: INTEL Corporation, Santa Clara, CA 95054 (US)
(72) Inventor: Yashar, Philip, Portland, 97229 (US); Malyavanatham, Gokul, Hillsboro, 97124 (US); Vijwani, Hema, Edmonds, 98026 (US)
(74) Representative: Goddar, Heinz J.

(57) **Abstract**

Integrated circuit interconnect structures including a niobium-based barrier material. In some embodiments, a layer of essentially niobium may be sputter deposited, for example to a thickness of less than 8 nm at a bottom of an interconnect via. A copper-based fill material may then be deposited over the niobium barrier material. Integrated circuit interconnect metallization may comprise some layers of metallization that have a tantalum-based barrier and other layers of metallization that have a niobium-based barrier.

## Description

### BACKGROUND

Demand for higher performance integrated circuits (ICs) in electronic device applications has motivated increasingly dense transistor architectures. Interconnect parasitics become a greater challenge as the density of interconnect metallization structures keeps pace with transistor density. For example, the resistance-capacitance (RC) delay associated with interconnects of an IC increases with the density of the interconnects.

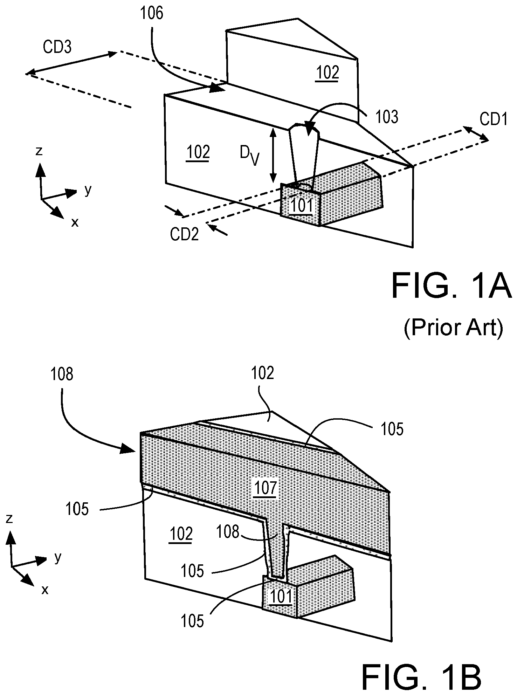

FIG. 1A illustrates a conventional interconnect structure that includes a metal line 101 within a first interconnect level. A transverse width of metal line 101 has some lateral critical dimension CD1. A dielectric material 102 is over metal line 101, and a "via" 103 is subtractively patterned through dielectric material 102 in the z-dimension to expose a portion of metal line 101. Via 103 has a depth Dv associated with the thickness of dielectric material 102. A diameter of via 103 has some lateral critical dimension CD2. Often, CD2 is made smaller than CD1 by an amount sufficient to ensure via 103 will land upon metal line 101. The ratio of depth Dv to CD2 is referred to as the aspect ratio of via 103. Metal line width CD1 scales down as metal line density increases with increasing transistor density, and so CD2 must also scale down and the aspect ratio of via 103 increases.

As further illustrated in FIG. 1B, via 103 and trench 106 is filled with one or more metals to form a metal line 108 that extends in the x-y dimension to intersect conductive material in via 103 so that two interconnect levels are electrically connected. In this example, a liner or barrier material 105 is on surfaces of trench 106 and via 103. Barrier material 105 may retard diffusion/migration of a fill material 107 out of the interconnect structure, as any loss of fill material 107 is generally catastrophic to an integrated circuit. At some minimum threshold layer thickness, barrier material 105 loses the ability to adequately retard diffusion/migration of fill material 107. Depending on the barrier material, this threshold barrier layer thickness may be in the 2-5nm range, for example.

Barrier material 105 often has significantly higher electrical resistance than fill material 107. As structural dimensions scale, barrier material 105 threatens to become a greater portion of an interconnect structure, leading to higher interconnect resistances. This issue particularly acute within a bottom of via 103 where barrier 105 spans the current-carrying cross-sectional area of via 103.

Accordingly, IC architectures offering a reduction in barrier material resistance would be commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A and 1B illustrate isometric cross-sectional views of an IC interconnect structure, in accordance with convention;
FIG. 2 is a flow chart of methods of fabricating one level of an integrated circuit interconnect structure having a niobium barrier material, in accordance with some embodiments;
FIG. 3A, 4A, 5A, and 6A illustrate a plan view of a portion of an IC interconnect structure evolving as the methods illustrated in FIG. 2 are practiced, in accordance with some dual-damascene embodiments;
FIG. 3B, 4B, 5B and 6B illustrate a cross-sectional view of a portion of an IC interconnect structure evolving as the methods illustrated in FIG. 2 are practiced, in accordance with some dual-damascene embodiments;
FIG. 7A, 8A and 9A illustrate a plan view of a portion of an IC interconnect structure evolving as the methods illustrated in FIG. 2 are practiced, in accordance with some single-damascene embodiments;
FIG. 7B, 8B and 9B illustrate a cross-sectional view of a portion of an IC interconnect structure evolving as the methods illustrated in FIG. 2 are practiced, in accordance with some single-damascene embodiments;
FIG. 10A and 10B illustrate plan and cross-sectional views of a portion of an IC interconnect structure evolving as the methods illustrated in FIG. 2 are practiced, in accordance with some alternative single-damascene embodiments;
FIG. 11A and 11B illustrate plan and cross-sectional views of a portion of an IC interconnect structure evolving as the methods illustrated in FIG. 2 are practiced, in accordance with some alternative single-damascene embodiments;
FIG. 12 is a flow chart of methods of fabricating one level of an integrated circuit interconnect structure having a Ta-based barrier material and another level of an integrated circuit interconnect structure having a Nb-based barrier material, in accordance with some embodiments;
FIG. 13 is a cross-sectional view of an integrated circuit with different barrier materials at different levels of interconnect metallization, in accordance with some embodiments;
FIG. 14 illustrates a mobile computing platform and a data server machine employing an IC including an interconnect structure with Nb barrier material, in accordance with some embodiments; and
FIG. 15 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

In accordance with embodiments herein, integrated circuit interconnect structures include a niobium (Nb) barrier material. Relative to other metals typically employed as an interconnect metallization barrier material, such as tantalum (Ta), Nb offers comparable diffusion barrier properties for a given barrier material layer thickness, but has superior electrical conductivity. Substantially pure Ta, for example, has an electrical resistivity around 190 µΩ•cm while the electrical resistivity of substantially pure Nb is around 35 µΩ• cm. Accordingly, electrical resistance of an interconnect metallization feature, such as a via or line, may be reduced through the practice of embodiments described herein.

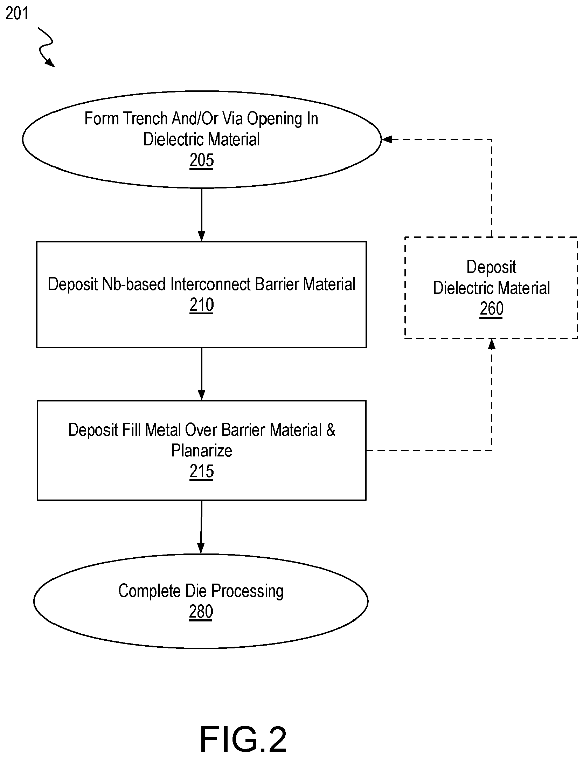

FIG. 2 is a flow chart of methods 201 for fabricating one level of an integrated circuit interconnect structure including a Nb-based barrier material, in accordance with some embodiments. Methods 201 may be practiced on a workpiece, such as a large format (e.g., 300-450mm) semiconductor wafer. The wafer may include a Group IV semiconductor material layer (e.g., Si, Ge, SiGe, GeSn, etc.), a Group III-V semiconductor material layer, or a Group II-VI semiconductor material layer, for example. The workpiece may include one or more underlying device layers including a semiconductor material layer, and may also have one or more interconnect levels interconnecting devices (e.g., transistors) of the device layers.

Methods 201 begin at input 205 where at least one of a trench or via opening is subtractively patterned into one or more dielectric materials of an IC interconnect structure. The trench and/or via interconnect structure may be any "dual-damascene" or "single-damascene" type structure patterned into any dielectric material(s) suitable as an IC interlayer dielectric material (ILD). In dual-damascene embodiments, both a trench and a via opening are patterned into the dielectric material at block 205. In single-damascene embodiments, only a via opening is patterned in a first iteration of block 205 while only a trench is patterned in a second iteration of block 205.

In some exemplary embodiments, the trench or via opening is formed in a low-k dielectric material, for example having a relative permittivity less than about 3.5. The trench or via opening may also be formed in a conventional dielectric material a somewhat higher relative permittivity in the range of 3.5-9. The trench or via opening may also be formed in a high-k dielectric material having an even higher relative permittivity, for example exceeding 9.5. In some specific examples, the trench or via opening is formed in any of SiOC(H), hydrogen silsesquioxane, methyl silsesquioxane, polyimide, polynorbornene, benzocyclobutene SiN, SiO, SiON, HfO₂, ZrO, or Al₂O₃.

At block 210, a barrier material is deposited over dielectric surfaces of the trench and/or via opening. In exemplary embodiments, the barrier material layer deposited at block 210 is Nb-based, meaning that the barrier material has a metal(s) content that is essentially niobium. Nb is referred to as the essential metal constituent in the barrier material because any other metal in the barrier material is not to materially increase the electrical resistivity of the barrier material from that of one with substantially pure Nb.

The Nb-based barrier material deposited at block 210 may be either metal (i.e., substantially pure Nb), or a Nb compound further comprising one or more non-metal constituents, such as Nb nitride (NbN), Nb boride (NbB), Nb carbide (NbC), or the like (e.g., carbon-doped NbN, etc.). For such compounds, the metals content is again essentially Nb. Any non-metal constituent content may be minimized for lowest electrical resistivity of the barrier material. In some embodiments, the Nb-based barrier material deposited at block 210 has no more than 5% non-metal constituents and may advantageously have less than 2% non-metals. There may be primarily one constituent (e.g., N or C), or two or more constituents (e.g., N and C) making up the percentage of non-metals.

The Nb-based barrier material may be deposited upon both dielectric and metallization surfaces at substantially the same rate (a non-selective deposition) so that the thickness of the barrier layer material formed upon underlying dielectric surfaces and underlying metallization surfaces is primarily a function of physical (e.g., solid angle) transport kinetics. In some exemplary embodiments, block 210 comprises a physical vapor deposition (PVD) process in which a Nb-based target material is sputtered upon exposed surfaces of the workpiece. A Nb-based target material is one which has a metal(s) content of essentially Nb. In some embodiments, of all metals in the Nb-based target material, the amount of Nb is advantageously more than 95%. In some embodiments, the Nb-based target material is substantially pure Nb with less than 4% of any other metal. For some embodiments where a Nb-based compound is deposited at block 210, the Nb-based target material may include the one or more non-metal constituents. For example, the Nb-based target material may have some amount (e.g., no more than 5%) of non-metal (e.g., N, B, C) content. In some exemplary embodiments where a barrier material of substantially pure Nb is deposited, the Nb-based target material comprises less than 4% of any impurity with respect to all elements of the period table. The Nb-based target material may be as high as 99% pure (e.g., 99.99% or 4N), but such a high purity is optional.

The PVD process practiced at block 210 is advantageously nonreactive so, as deposited, the Nb-based barrier material is substantially the same composition as that of the Nb-based target material sputtered. Alternatively, a reactive PVD process may be practiced at block 210 so, as deposited, a Nb-based barrier material is a compound of predominantly the composition of the Nb-based target material. For some embodiments where a Nb-based compound is deposited at block 210, the Nb-based target material may be substantially pure Nb sputtered in a reactive environment further comprises the one or more non-metal constituents (e.g., N, B, C).

An interface material layer, such as an adhesion layer, of some other composition may also be deposited at block 210. However, in advantageous embodiments, the Nb-based barrier material is deposited in direct contact with the underlying dielectric surfaces of the trench and/or via opening.

Methods 201 continue at block 215, where one or more fill materials are deposited. An interface material layer may also be deposited at block 215. However, in advantageous embodiments, fill material is deposited in direct contact with the Nb-based barrier material. The fill material deposited at block 215 has a different composition than the barrier material deposited at block 210. In exemplary embodiments, the fill material deposited at block 215 comprises at least one of Cu, Mo, Co, Ru, or W.

Any deposition process known to be suitable for depositing a particular fill material into a trench and/or via opening may be practiced at block 215 as embodiments are not limited in this respect. In some examples, an electrolytic plating process is practiced at block 215 to deposit a fill metal. In further embodiments, multiple deposition processes may be practiced at block 215. For example, an electrolytic plating process may be preceded by PVD of a seed layer. Deposition of the fill materials may also comprise chemical vapor deposition (CVD), atomic layer deposition (ALD) or electroless plating. For example, a seed or wetting material layer may be deposited by PVD, CVD, ALD or electroless plating prior to the electrolytic plating of a fill metal.

Block 215 is completed with a planarization of at least the fill materials and the barrier material to expose a top surface of the dielectric material surrounding the trench or via opening. The planarization process may remove any fill material and barrier material from the dielectric material in regions beyond a perimeter of an interconnect structure. Any planarization (e.g., CMP) process may be practiced to complete metallization of an interconnect feature.

For dual-damascene embodiments, methods 201 are substantially complete following block 220 with one level of interconnect fabricated. Methods 201 may be repeated for each successive interconnect level that is to include a dual-damascene interconnect structure. Alternatively, in single-damascene embodiments where only a via opening is filled at block 215, methods 201 may continue with block 260 where a dielectric material is deposited over the interconnect via formed thus far. Any deposition process known to be suitable for forming an ILD may be practiced at block 260 as embodiments herein are not limited in this respect.

Methods 201 may then continue with a second iteration of block 205 where a trench is formed in the dielectric material deposited at block 260 to expose a portion of the interconnect via. At block 210, a Nb-based barrier material layer(s) is again deposited. Hence, for single-damascene embodiments, two barrier material deposition blocks 210 may be practiced. Methods 201 may then continue with another implementation of fill block 215 where one or more fill materials are deposited at planarized to compete one level of interconnect.

Methods 201 complete at output 280, where any backend of line processing may be performed. One or more additional interconnect levels may be fabricated at output 280, for example by practicing blocks 210, 215 and 260 once or twice for each interconnect level fabrication. Output 280 may also include the fabrication of backside metallization where any processing of the backside of the workpiece may be performed. For example, one or more backside interconnect levels may be fabricated at output 280. In some embodiments, blocks 210, 215 and 260 are practiced once or twice for each level of backside interconnect metallization fabricated.

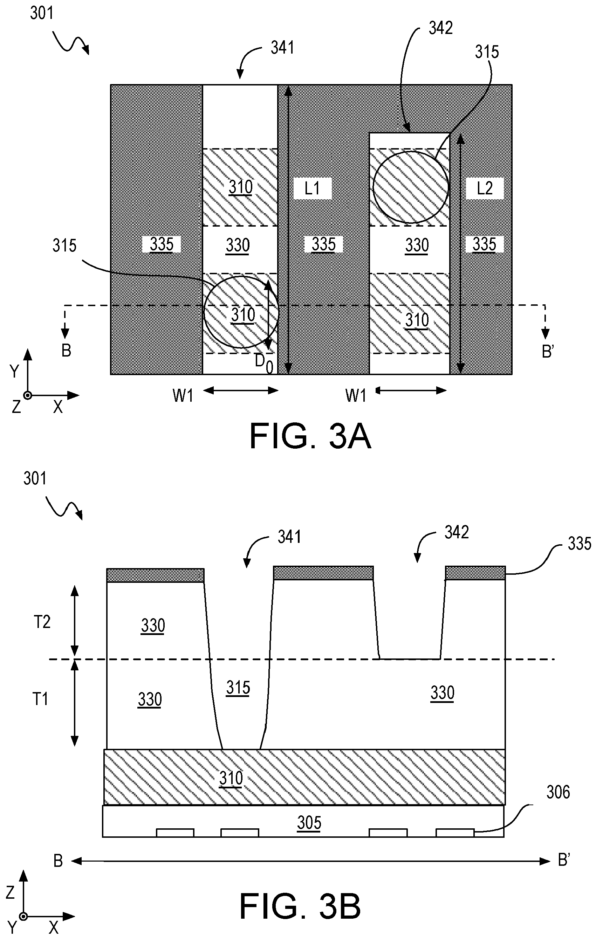

FIG. 3A, 4A, 5A, and 6A illustrate a plan view of a portion of an IC interconnect structure 301evolving as the methods 201 are practiced, in accordance with some dual-damascene embodiments. FIG. 3B, 4B, 5B and 6B further illustrate a cross-sectional view of a portion of IC interconnect structure 301 evolving, in accordance with some dual-damascene embodiments.

Referring first to FIG. 3A and FIG. 3B, interconnect structure 301 includes a via opening 315 through a thickness T1 of one or more dielectric materials 330. Thickness T1 may vary with implementation, but in some exemplary embodiments is 10nm-50nm. An underlying metallization feature (e.g., a line) 310 is exposed at a bottom of via opening 315. Metallization feature 310 is in a lower interconnect level below dielectric materials 330. Metallization feature 310 may have any composition, with some examples including copper, tungsten, titanium, cobalt, ruthenium, molybdenum, manganese, or aluminum. In FIG. 3A, portions of metallization feature 310 outlined in dashed line are below the surface.

Interconnect structure 301 further includes trench 341 over via opening 315, within a thickness T2 of dielectric materials 330. Thickness T2 may vary with implementation, but in some exemplary embodiments is 10-50 nm, or more. Another trench 342 laterally spaced apart from trench 341 is further illustrated, and the cross-section of trench 342 shown in FIG. 3B is representative of a cross-section of trench 341 out of the plane of the FIG. 3B where there is no via opening 315. As shown in FIG. 3A, trench 341 has a longitudinal length L₁ and a transverse width W₁. In exemplary embodiments, longitudinal length L₁ is significantly (e.g., 3x) larger than transverse width W₁. Although not illustrated, trench 341 has ends somewhere beyond the perimeter of interconnect structure 301. Trench 342 is substantially parallel to trench 341, but with a shorter longitudinal length L₂ to further illustrate a trench end. An etch stop material layer 335 is over dielectric materials 330, surrounding trenches 341, 342. Via opening 315 has a maximum lateral diameter D₀, which may vary with implementation, but is generally significantly smaller than the length of a trench (e.g., diameter D₀ is significantly smaller than longitudinal lengths L₁ and L₂).

Any single-step or multi-step anisotropic reactive ion etch (RIE) process (e.g., based on a CₓF_{y} plasma chemistry) may be practiced to form trenches 341, 342 and via opening 315, as embodiments are not limited in this respect. Trenches 341, 342 and via opening 315 are depicted with a tapered sidewall and positive slope such that a top width of via opening 315 is slightly larger than the bottom width. While such tapered slope is representative of subtractively patterned dielectrics, other profiles are possible as a function of the dielectric etch process.

Dielectric materials 330 may include any dielectric material suitable for electrical isolation of integrated circuitry. Dielectric materials 330, may, for example, be low-k dielectric materials (e.g., SiOC) having a relative permittivity below 3.5. In other examples, dielectric materials 330 may be any of SiO, SiON, hydrogen silsesquioxane, methyl silsesquioxane, polyimide, polynorbornenes, benzocyclobutene, or the like. Dielectric materials 330 may be deposited as a flowable oxide, for example, and have a substantially planar top surface. Etch stop material layer 335 may also be a dielectric material, but advantageously has a different composition than dielectric materials 330. Etch stop material layer 335 may have a somewhat higher relative permittivity than dielectric materials 330, for example. Etch stop material layer 335 may have any composition such as, but not limited to, SiN, SiO, SiON, HfO₂, ZrO, Al₂O₃, for example. Etch stop material layer 335 may have any thickness, but in some advantageous embodiments has a thickness less than 10nm, and advantageously no more than 5nm (e.g., 2-3nm, etc.). In accordance with some further embodiments, dielectric materials 330 may further include an intervening trench etch stop material layer represented as a dashed line between dielectric material thicknesses T1 and T2.

As further shown in FIG. 3B, interconnect structure 301 is over a portion of an underlying substrate that includes a device layer 305. Within device layer 305 are a plurality of devices 306. In exemplary embodiments, devices 306 are metal-oxide-semiconductor field effect transistor (MOSFET) structures. However, devices 306 may also be other transistor types, such as, but not limited to other FET architectures, or bipolar junction transistors. Devices 306 may also be other devices that include one or more semiconductor junctions (e.g., diodes, etc.).

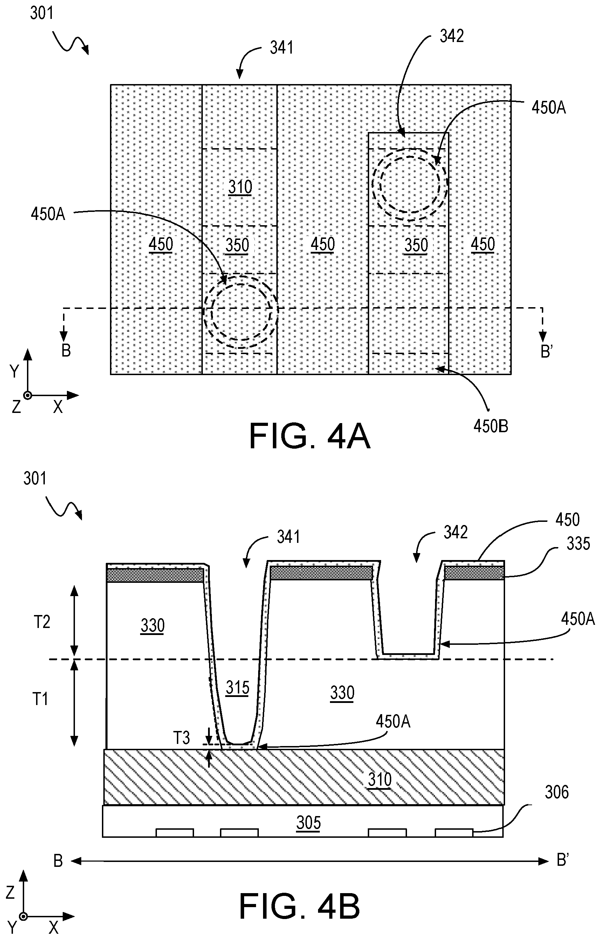

In the example further illustrated in FIG. 4A and FIG. 4B, a barrier material 450 has been formed over interconnect structure 301. In the illustrated embodiments, barrier material 450 is in physical contact with dielectric material 330, but there may instead be some intervening (e.g., adhesion) material layer. As shown, barrier material 450 includes a bottom barrier region 450A within via opening 315. Bottom barrier region 450A has a thickness T3. In exemplary embodiments, thickness T3 is less than 10 nm, advantageously less than 8 nm. Thickness T3 may be at least 3 nm (e.g., 3-5 nm), to ensure adequate barrier material thickness on sidewalls of dielectric material 330 within via opening 315.

Barrier material 450 is Nb-based material, and may for example, have been deposited at block 210 of methods 201 (FIG. 2). Barrier material 450 (FIG. 4B) may therefore have any of the compositions described above and advantageously has a metal(s) content that is essentially niobium. Hence, Nb is the essential metal constituent in barrier material 450 and any other metal in barrier material 450 does not materially increase the electrical resistivity of the barrier material from that of substantially pure Nb.

The barrier material 450 may be either substantially pure Nb or a substantially pure Nb compound, such as NbN or NbC, that further comprises one or more non-metal constituents. Of all metals in barrier material 450, the amount of Nb is more than 95%. Advantageously, there less than 4% of any other metal and more advantageously less than 3%. For embodiments where barrier material 450 is a Nb metallic compound, the metals content of barrier material 450 is essentially Nb. For lowest electrical resistivity, there is minimal non-metal content in barrier material 450. In some embodiments, barrier material 450 has no more than 5% non-metal constituents and advantageously has less than 3% non-metals. There may be primarily one constituent (e.g., N or C), or two or more constituents (e.g., N and C) making up the percentage of non-metals.

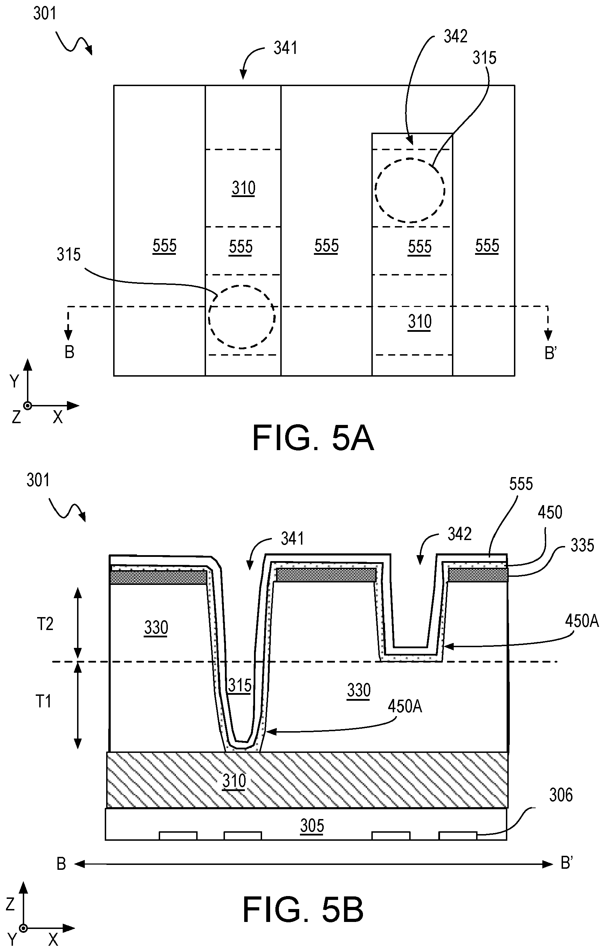

In the example further illustrated in FIG. 5A and FIG. 5B, interconnect structure 301 further includes an interconnect metal fill comprising a fill material layer 555. Fill material layer 555 may be any metal that may enhance the formation or properties of another fill material. Fill material layer 555 may, for example, function as a seed or wetting layer improving the fill of another fill material subsequently deposited. In some embodiments, fill material layer 555 comprises predominantly copper deposited by PVD. In other embodiments, fill material layer 555 may comprises predominantly cobalt, again deposited by PVD. In the illustrated embodiments, fill material layer 555 is in physical contact with barrier material 450, but there may also be some intervening material layer.

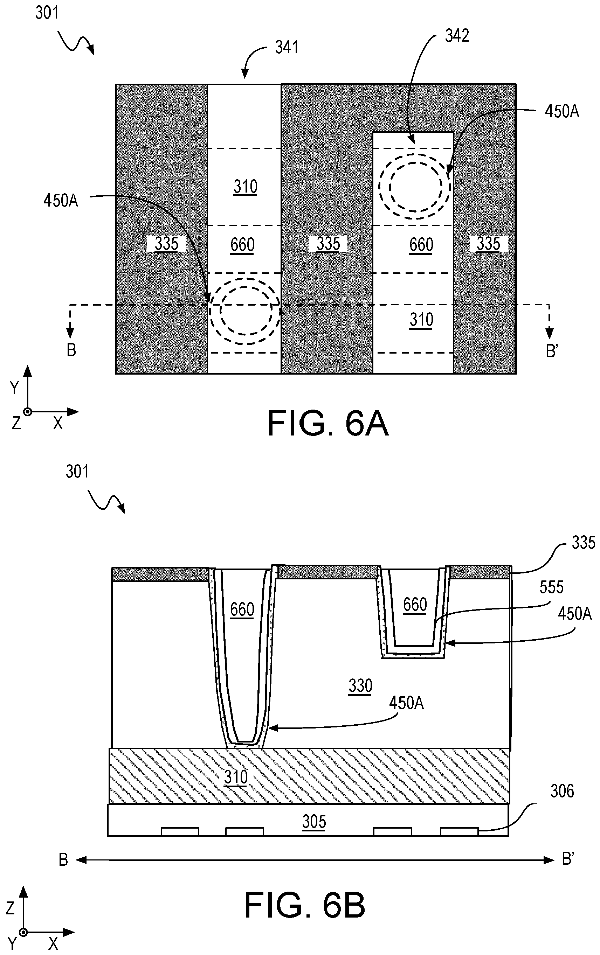

In the example further illustrated in FIG. 6A and FIG. 6B, another fill material layer 660 substantially backfills both via opening 315 and trenches 341 and 342. In some embodiments, fill material layer 660 comprises predominantly copper, or an alloy thereof. Although two metal fill material layers 555 and 660 are illustrated, for embodiments where the composition of fill layer 555 (e.g., as a seed) is substantially the same as the composition of fill layer 660, an interface between fill material layers 555 and 660 may not be apparent in practice. Following planarization, fill material layers 555 and 660, as well as barrier material 450, are substantially planar with a top surface of the workpiece (e.g., etch stop material layer 335).

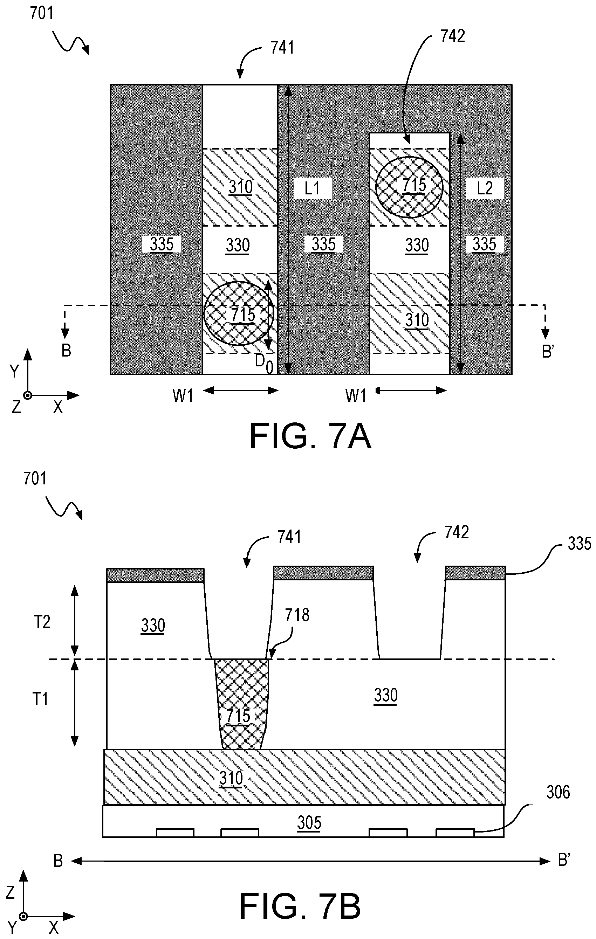

FIG. 7A, 8A and 9A illustrate a plan view of a portion of an IC interconnect structure 701 evolving as methods 201 are practiced, in accordance with some single-damascene embodiments. FIG. 7B, 8B and 9B further illustrate a cross-sectional view of a portion of IC interconnect structure 701, in accordance with some single-damascene embodiments. Reference numbers are retained where one or more of the attributes introduced above are also applicable to interconnect structure 701.

Referring first to FIG. 7A and FIG. 7B, interconnect structure 701 includes a via 715 extending through a thickness T1 of one or more dielectric materials 330. Via 715 comprises a fill material that is electrically coupled to underlying metallization feature 310. Via 715 may have been fabricated according to a first single-damascene process, for example. In this example, via 715 has no barrier material, and may comprise any fill material suitable for a barrier-less via, such as, but not limited to, tungsten, molybdenum, titanium, cobalt, or ruthenium, for example. Without a barrier material, the via fill material is in physical contact with metallization feature 310. A top surface of via 715 is exposed at a bottom of trench 741 patterned into dielectric materials 330. As a result of separate patterning of via 715 and trench 741, there is a non-zero lateral offset or profile discontinuity 718 at the interface of the sidewall of trench 741 and a sidewall of via 715. Etch stop material layer 335 is again over dielectric materials 330, surrounding trenches 341, 342. As further shown in FIG. 7B, interconnect structure 701 is again over a portion of an underlying substrate that includes a device layer 305 with a plurality of devices 306 (e.g., transistors).

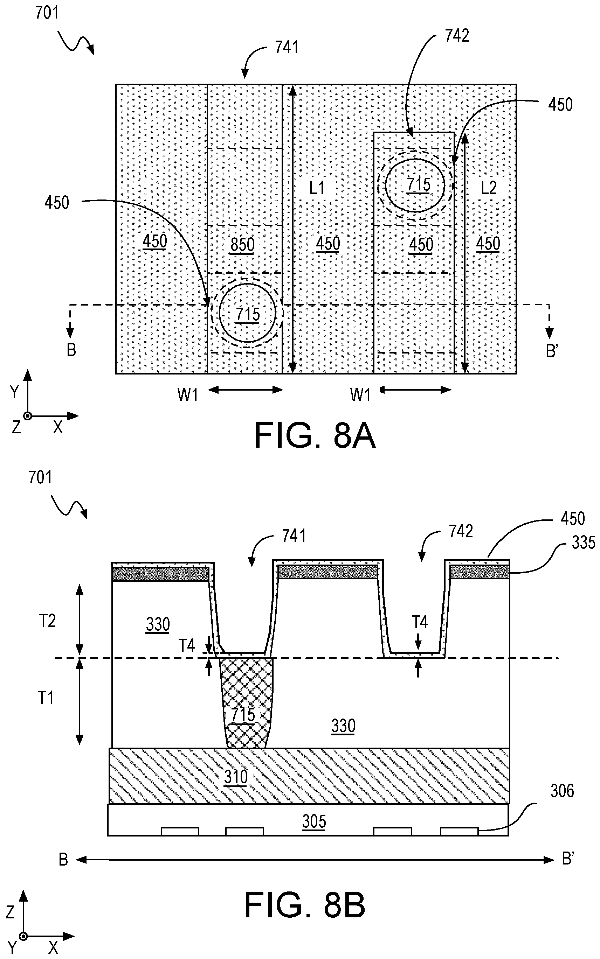

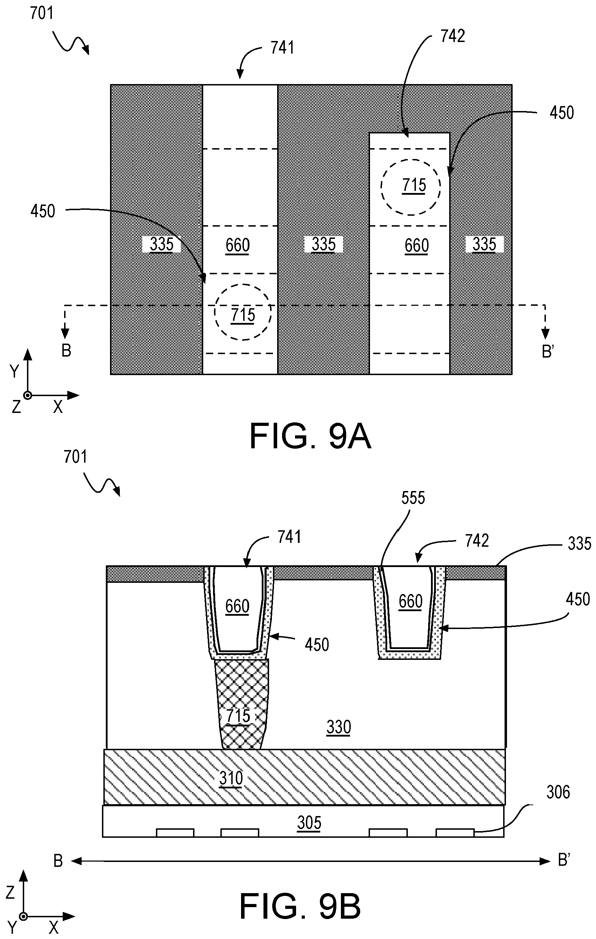

In the single-damascene example further illustrated in FIG. 8A and FIG. 8B, barrier material 450 includes a bottom trench region having a thickness T4. Thickness T4 is at least equal to via bottom barrier thickness T3 and may be greater than thickness T3, for example because of a lower aspect ratio. Barrier material 450 may have any of the compositions described above in the context of a dual-damascene interconnect structure. As further illustrated in FIG. 9A and FIG. 9B, the interconnect fill includes fill material (e.g., seed) layer 555 and layer 660, which substantially backfills trenches 741 and 742. Fill material layer 660 and barrier material 450 are substantially co-planar with a top surface of the workpiece (e.g., etch stop material layer 335).

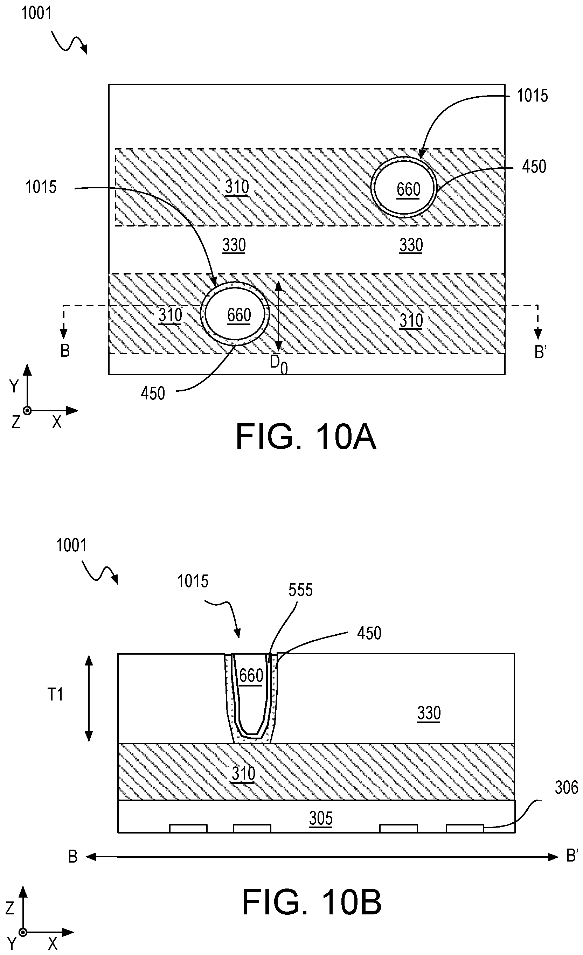

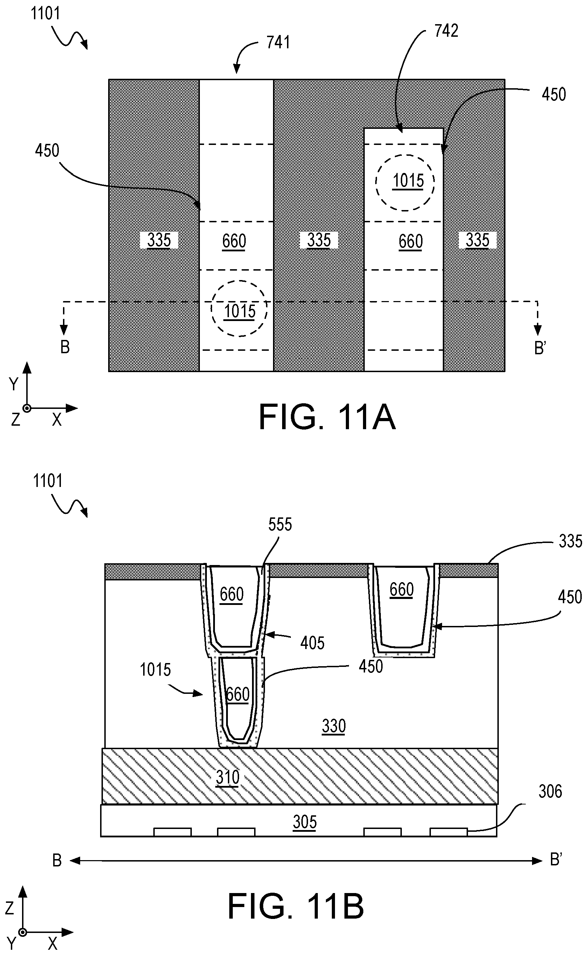

For some single-damascene structures, a via may have a Nb-based barrier instead of the barrierless example shown in FIGs. 7-9. In FIG. 10A and 10B for example, interconnect structure 1101 includes via 1015 with fill material 660 surrounded by barrier material 450. Any interconnect line may then be fabricated over via 1015 either with a line metallization deposition and subtractive metal line etch process, or with a dielectric deposition and subtractive dielectric etch process followed by a damascene line metallization process. Hence, for some single-damascene structures, an interconnect via may have Nb-based barrier material, for example as illustrated in FIG. 11A and 11B, and the line metallization may also have a Nb-based barrier.

As shown in FIG. 11A and FIG. 11B, interconnect structure 1101 includes via 1015 with fill material 660 surrounded by barrier material 450. Interconnect structure 1101 further includes trenches 741, 742 with fill material 660 surrounded by barrier material 450. Although in such examples the barrier material is substantially the same for both via 1015 and trenches 741, 742, in alternative embodiments two different barrier materials may be employed within an interconnect structure. For example, a first of via metallization or line metallization may have a Ta-based (e.g., pure Ta or TaN, etc.) barrier material while a second of the via metallization or the line metallization may have the Nb-based barrier material substantially as described above. The barrier material composition of interconnect metallization structures may also differ across a plurality of metallization levels within an IC die. The barrier material composition of interconnect metallization structures may also differ between frontside metallization fabricated on a first side of the workpiece and backside metallization fabricated on an opposite side of the workpiece.

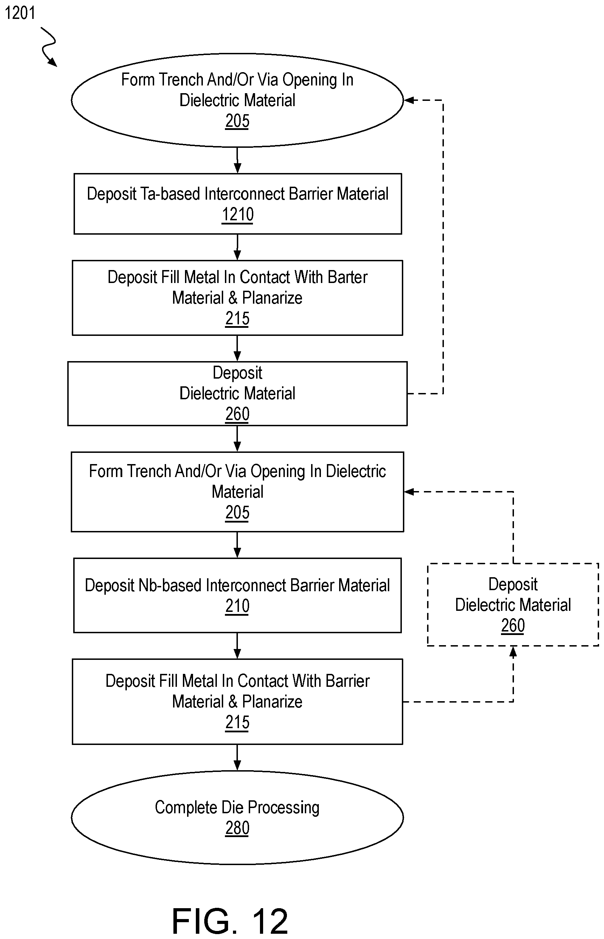

FIG. 12 is a flow chart of methods 1201 for fabricating one level of an integrated circuit interconnect structure having a Ta-based barrier material and another level of an integrated circuit interconnect structure having a Nb-based barrier material, in accordance with some embodiments. Methods 1201 may be similarly practiced on a workpiece, such as a large format (e.g., 300-450mm) semiconductor wafer. The workpiece may similarly include one or more underlying device layers including a semiconductor material layer, and may also have one or more interconnect levels interconnecting devices (e.g., transistors) of the device layers.

Methods 1201 again begin at input 205 where at least one of a trench or via opening is subtractively patterned into one or more dielectric materials of an IC interconnect structure. The trench and/or via interconnect structure may be any "dual-damascene" or "single-damascene" type structure patterned into any dielectric material(s) suitable as an IC interlayer dielectric material (ILD).

At block 1210, a first barrier material is deposited over dielectric surfaces of the trench and/or via opening. This first barrier material is other than a Nb-based material. The barrier material deposited at block 1210 may have any other composition known to be suitable as a diffusion barrier at some threshold thickness. In some examples, the barrier material deposited at block 1210 comprises a metal, such as, but not limited to, Ta, Mo, W, or Al. The barrier material deposited at block 12010 may also comprise a metal compound that further includes at least one of Si, N, C, B, P or O. In some specifical embodiments, the barrier material deposited at block 1210 comprises nitrogen (e.g., TaN, WN, etc.).

Tantalum-based barrier materials (e.g., pure Ta, as well as metallic compounds of Ta) can function as a good diffusion barrier of many interconnect fill metals, such as Cu. A Ta-based barrier material may be deposited at block 1210 with an ALD process in which deposition precursor molecules are adsorbed to dielectric and/or metal surfaces of the workpiece. In some embodiments, a tantalum precursor, such as, but not limited to, Pentakis(dimethylamido)tantalum, is introduced. The ALD process may further comprise co-reactant phase during which adsorbed deposition precursor molecules are chemically reacted to deposit the barrier material. The co-reactant phase may include a plasma, for example to promote chemical reaction at low temperatures. As deposited, the barrier material may be either predominantly a metal or predominantly a metallic compound, such as a metal nitride, metal boride, metal carbide, or the like (e.g., carbon-doped nitride, etc.). In some embodiments where a Ta precursor is reacted with a nitride source, such as ammonia (NH₃), a TaN barrier material is deposited at block 1210.

Any number of ALD cycles including deposition precursor and/or co-reactant phases may be executed at operation 1210 to deposit the barrier material to a desired target thickness. In some embodiments, a Ta-based barrier material is deposited to a thickness less than 3 nm, and may be 1-2nm, for example.

Methods 1201 continue at block 215, where one or more fill materials are deposited in contact with the barrier material. The fill metal has a different composition than the barrier material deposited at block 1210, and in exemplary embodiments comprises at least one of Cu, Mo, Co, Ru, or W.

Methods 1201 may continue with block 260 where a dielectric material is deposited over the interconnect metallization structure and one or more additional layers of metallization with the first barrier material may be fabricated by iteratively practicing blocks 205-260. After fabricating a predetermined number of interconnect metallization levels, methods 1201 continue with the formation of another via opening or trench in a dielectric material at a second instance of block 205, which is followed by deposition of a Nb-based interconnect barrier material at block 210. Block 210 may be substantially as described elsewhere herein, for example depositing a substantially pure Nb barrier.

Methods 1201 then continue with a second implementation of block 215, where one or more fill materials are deposited in contact with the Nb-based barrier material. The fill metal deposited has a different composition than the barrier material deposited at block 210, and in exemplary embodiments comprises at least one of Cu, Mo, Co, Ru, or W.

Methods 1201 may continue with another implementation of block 260 where a dielectric material is deposited over the interconnect metallization structure and one or more additional layers of metallization with the second barrier material may be fabricated by iteratively practicing blocks 205-260. Methods 1201 then end at output 280 where the die processing is completed accordingly to any conventional techniques.

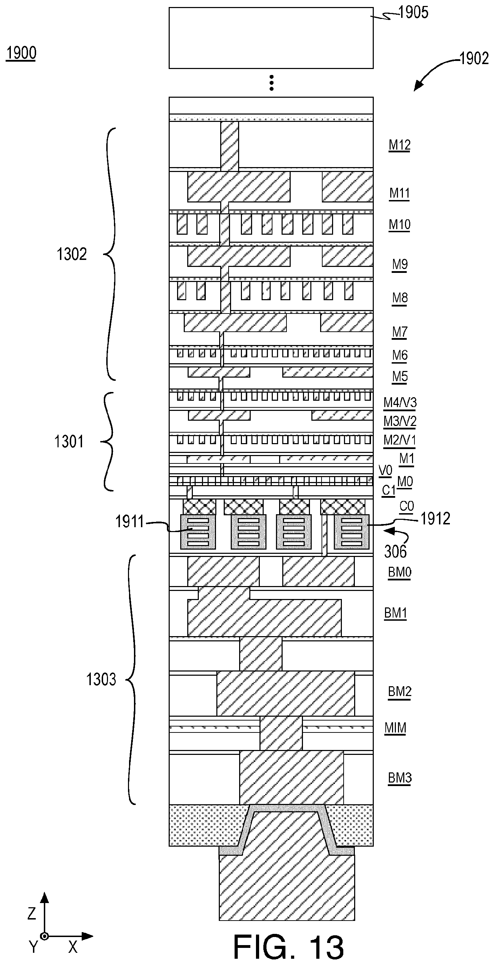

FIG. 13 is a cross-sectional view of a system including a heat sink 1905 and an IC die 1902 incorporating different barrier materials at different levels of interconnect metallization, in accordance with some embodiments. IC die 1902 may be fabricated, at least in part, through the practice of methods 1201, for example.

As shown in FIG. 13, IC die 1902 includes M0-M12 levels of interconnect metallization features are over a front side of devices 306, which in this example include stacked nanosheet transistors with a gate stack 1912 surrounding semiconductor material nanosheets 1911. In some embodiments, a first plurality of metallization levels 1301 (e.g., including M0-M4) include a first barrier material (e.g., Ta-based) that may be deposited to a lesser thickness with a first technique (e.g., ALD) well-suited to more aggressively scaled metallization features. In some further embodiments, a second plurality of metallization levels 1302 (e.g., including M5-M12) include a second barrier material (e.g., Nb-based) that may be deposited to a greater thickness with a second technique (e.g., PVD) well-suited to less aggressively scaled metallization features and much less expensive than ALD techniques. Accordingly, the electrical resistance contribution of metallization levels 1302 may be reduced relative to an IC die with a Ta-based barrier in all metallization levels. Furthermore, a cost of manufacturing IC die 1902 may be reduced relative to an IC die that has a Ta-based barrier in all metallization levels.

As further illustrated in FIG. 13, IC die 1902 includes backside metallization levels BM0-BM3 over a backside of devices 306. Backside metallization may couple electrical power into IC die 1902 from a host component (not depicted). Backside metallization levels BM0 through M3 may comprise IC an interconnect structure 1303 (FIG. 13B), for example including a Nb-based barrier material, for example substantially as described elsewhere herein. For such embodiments, one or both of metallization levels 1301 and 1302 may include Ta-based barrier material.

Interconnect structures 301, 701, 1101, 1301, 1302 and 1301 may each be incorporated into any IC device as a portion of any IC chip or die that may be singulated from a workpiece following the completion of any conventional processing. With a barrier material of essentially Nb, interconnect metallization resistance, and more particularly via electrical resistance, may be reduced. IC devices may therefore display a lower RC delay and higher overall performance. An IC device may also display lower power consumption and lower temperatures for a given level of performance.

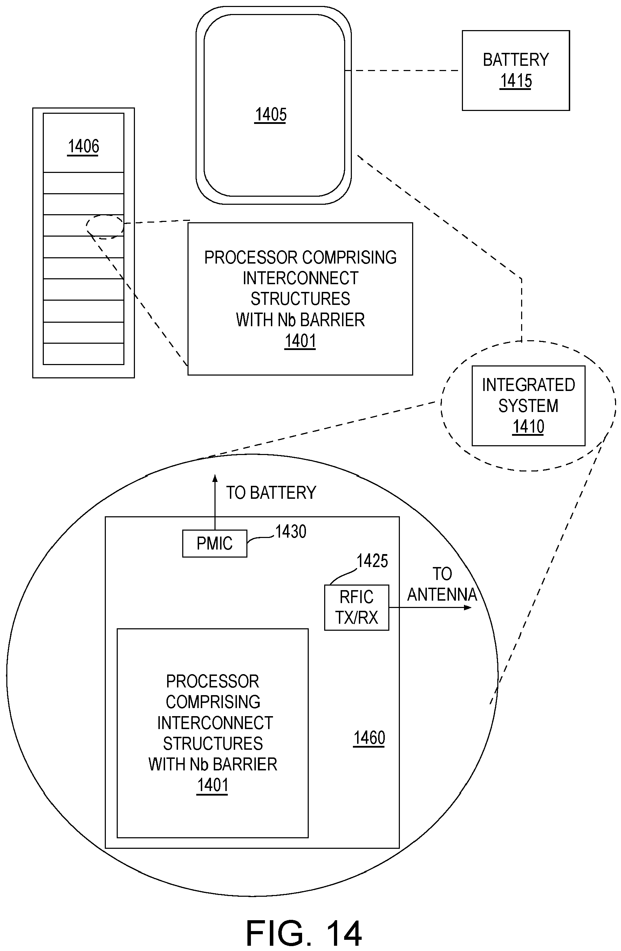

FIG. 14 illustrates a mobile computing platform 1405 and a data server machine 1406 employing a processor circuit comprising interconnect structures with a Nb barrier material, for example as described elsewhere herein. Server machine 1406 may be any commercial server, for example including any number of high-performance computing platforms disposed within a rack and networked together for electronic data processing. The mobile computing platform 1405 may be any portable device configured for each of electronic data display, electronic data processing, wireless electronic data transmission, or the like. For example, the mobile computing platform 1405 may be any of a tablet, a smart phone, laptop computer, etc., and may include a display screen (e.g., a capacitive, inductive, resistive, or optical touchscreen), an integrated system 1410, and a battery 1415.

As illustrated in the expanded view, multi-chip device 1560 is coupled to one or more of a power management integrated circuit (PMIC) 1430 or RF (wireless) integrated circuit (RFIC) 1425 including a wideband RF (wireless) transmitter and/or receiver. A PMIC may perform battery power regulation, DC-to-DC conversion, etc., and so has an input coupled to battery 1415 and with an output providing a current supply to other functional modules. As further illustrated, in the exemplary embodiment, an RFIC has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, and beyond.

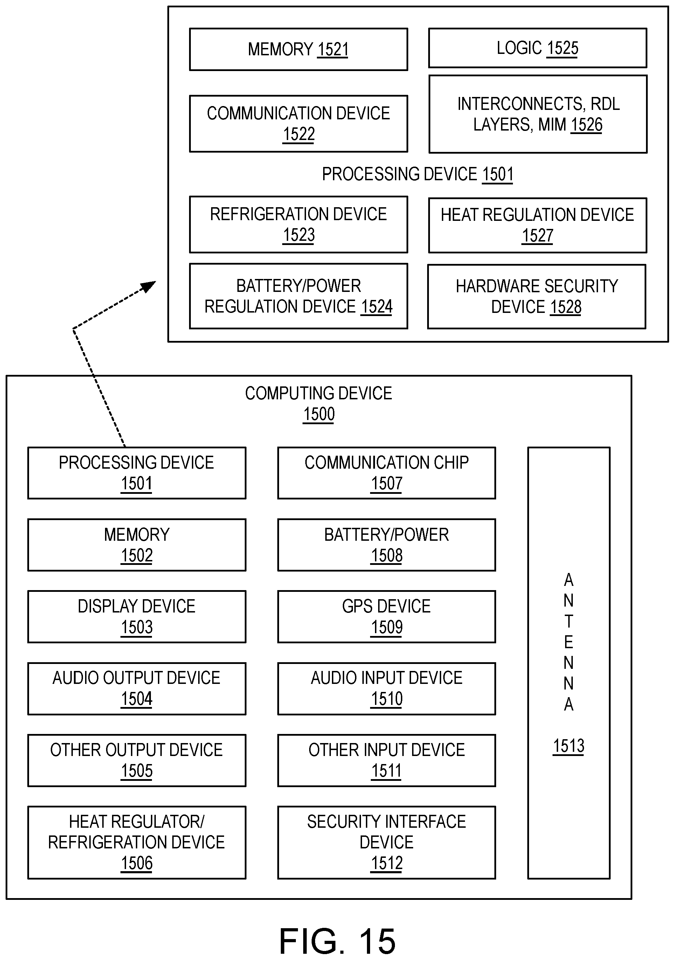

FIG. 15 is a block diagram of a cryogenically cooled computing device 1500 in accordance with some embodiments. For example, one or more components of computing device 1500 may include any of the devices or structures discussed elsewhere herein. A number of components are illustrated in FIG. 15 as included in computing device 1500, but any one or more of these components may be omitted or duplicated, as suitable for the application. In some embodiments, some or all of the components included in computing device 1500 may be attached to one or more printed circuit boards (e.g., a motherboard). In some embodiments, various ones of these components may be fabricated onto a single system-on-a-chip (SoC) die. Additionally, in various embodiments, computing device 1500 may not include one or more of the components illustrated in FIG. 15, but computing device 1500 may include interface circuitry for coupling to the one or more components. For example, computing device 1500 may not include a display device 1503, but may include display device interface circuitry (e.g., a connector and driver circuitry) to which display device 1503 may be coupled.

Computing device 1500 may include a processing device 1501 (e.g., one or more processing devices). As used herein, the term processing device or processor indicates a device that processes electronic data from registers and/or memory to transform that electronic data into other electronic data that may be stored in registers and/or memory. Processing device 1501 may include a memory 1521, a communication device 1522, a refrigeration/active cooling device 1523, a battery/power regulation device 1524, logic 1525, interconnects 1526, a heat regulation device 1527, and a hardware security device 1528.

Processing device 1501 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1501 may include a memory 1502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1521 includes memory that shares a die with processing device 1502. This memory may be used as cache memory and may include embedded dynamic random-access memory (eDRAM) or spin transfer torque magnetic random-access memory (STT-M RAM).

Computing device 1500 may include a heat regulation/refrigeration device 1506. Heat regulation/refrigeration device 1506 may maintain processing device 1502 (and/or other components of computing device 1500) at a predetermined low temperature during operation. This predetermined low temperature may be any temperature discussed elsewhere herein.

In some embodiments, computing device 1500 may include a communication chip 1507 (e.g., one or more communication chips). For example, the communication chip 1507 may be configured for managing wireless communications for the transfer of data to and from computing device 1500. The term "wireless" and its derivatives may be used to describe circuits, devices, systems, methods, techniques, communications channels, etc., that may communicate data through the use of modulated electromagnetic radiation through a nonsolid medium.

Communication chip 1507 may implement any wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1507 may operate in accordance with other wireless protocols in other embodiments. Computing device 1500 may include an antenna 1513 to facilitate wireless communications and/or to receive other wireless communications (such as AM or FM radio transmissions).

In some embodiments, communication chip 1507 may manage wired communications, such as electrical, optical, or any other suitable communication protocols (e.g., the Ethernet). As noted above, communication chip 1507 may include multiple communication chips. For instance, a first communication chip 1507 may be dedicated to shorter-range wireless communications such as Wi-Fi or Bluetooth, and a second communication chip 1507 may be dedicated to longer-range wireless communications such as GPS, EDGE, GPRS, CDMA, WiMAX, LTE, EV-DO, or others. In some embodiments, a first communication chip 1507 may be dedicated to wireless communications, and a second communication chip 1507 may be dedicated to wired communications.

Computing device 1500 may include battery/power circuitry 1508. Battery/power circuitry 1508 may include one or more energy storage devices (e.g., batteries or capacitors) and/or circuitry for coupling components of computing device 1500 to an energy source separate from computing device 1500 (e.g., AC line power).

Computing device 1500 may include a display device 1503 (or corresponding interface circuitry, as discussed above). Display device 1503 may include any visual indicators, such as a heads-up display, a computer monitor, a projector, a touchscreen display, a liquid crystal display (LCD), a light-emitting diode display, or a flat panel display, for example.

Computing device 1500 may include an audio output device 1504 (or corresponding interface circuitry, as discussed above). Audio output device 1504 may include any device that generates an audible indicator, such as speakers, headsets, or earbuds, for example.

Computing device 1500 may include an audio input device 1510 (or corresponding interface circuitry, as discussed above). Audio input device 1510 may include any device that generates a signal representative of a sound, such as microphones, microphone arrays, or digital instruments (e.g., instruments having a musical instrument digital interface (MIDI) output).

Computing device 1500 may include a global positioning system (GPS) device 1509 (or corresponding interface circuitry, as discussed above). GPS device 1509 may be in communication with a satellite-based system and may receive a location of computing device 1500, as known in the art.

Computing device 1500 may include another output device 1505 (or corresponding interface circuitry, as discussed above). Examples include an audio codec, a video codec, a printer, a wired or wireless transmitter for providing information to other devices, or an additional storage device.

Computing device 1500 may include another input device 1511 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1500 may include a security interface device 1512. Security interface device 1512 may include any device that provides security measures for computing device 1500 such as intrusion detection, biometric validation, security encode or decode, managing access lists, malware detection, or spyware detection.

Computing device 1500, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure. The embodiments described can therefore be practiced with modification and alteration without departing from the scope of the appended claims. For example, the above embodiments may include specific combinations of features as further provided below.

In first examples, an integrated circuit (IC) interconnect structure comprises a dielectric material and a line or via metallization adjacent to the dielectric material. The line or via metallization comprises a fill material comprising a first metal, and a barrier material between the fill material and the dielectric material. The barrier material havs a metal content consisting essentially of Nb.

In second examples, for any of the first examples the first metal is Cu, Co, Mo, or W.

In third examples, for any of the first through second examples the barrier material is more than 95% pure Nb.

In fourth examples, for any of the first through third examples the barrier material is in direct contact with the dielectric material and wherein the fill material is in direct contact with the barrier material.

In fifth examples, for any of the first through fourth examples the barrier material has a thickness of no more than 8 nm at a bottom of the line or via metallization.

In sixth examples, for any of the fifth examples the barrier material has a thickness of at least 3 nm at the bottom of the line or via metallization.

In seventh examples, for any of the first through sixth examples the IC interconnect structure comprises a first line metallization under the dielectric material, a via metallization through the dielectric material, and coupled to the first line metallization, and a second line metallization over, and coupled to, the first line metallization through the via metallization. At least the via metallization comprises the fill material and the barrier material, the barrier material at a bottom of the via metallization in direct contact with the first line metallization.

In eighth examples, an integrated circuit (IC) device comprises a plurality of transistors comprising one or more semiconductor materials, and a plurality of interconnect levels coupled to the plurality of transistors. A first of the interconnect levels further comprises a first line or via metallization comprising a first barrier material and a fill material, the first barrier material comprising Ta. A second of the interconnect levels further comprises a second line or via metallization comprising a second barrier material and a fill material, the second barrier material comprising Nb.

In ninth examples, for any of the eighth examples the first barrier material has a first thickness, less than a second thickness of the second barrier material.

In tenth examples, for any of the eighth through ninth examples the first thickness is less than 3nm at a bottom of a first via metallization, and the second thickness is at least 3 nm at a bottom of a second via metallization.

In eleventh examples, for any of the eighth through tenth examples the second barrier material consists essentially of Nb.

In twelfth examples, for any of the eleventh examples the second barrier material is substantially pure Nb.

In thirteenth examples, for any of the eighth through twelfth examples the first of the interconnect levels is a lower level of interconnect metallization that is over a front side of the transistors and wherein the second of the interconnect levels is an upper level of the interconnect metallization that is over the front side of the transistors.

In fourteenth examples, for any of the eighth through twelfth examples the first of the interconnect levels is over a front side of the transistors, and wherein the second of the interconnect levels is over a back side of the transistors.

In fifteenth examples, for any of the eighth through fourteenth examples the IC device further comprises a power supply coupled to power the (IC) device through one or more host components between the power supply and the IC device.

In sixteenth examples, a method of fabricating an integrated circuit (IC) interconnect structure comprises forming at least one of a via opening or a trench in a dielectric material, depositing a barrier material on a surface of the dielectric material, the barrier material consisting essentially of Nb, and depositing a fill material over the barrier material within the via opening or the trench.

In seventeenth examples, for any of the sixteenth examples depositing the barrier material comprises sputtering a target having a metal content consisting essentially of Nb.

In eighteenth examples, for any of the seventeenth examples the target is at least 95% pure Nb.

In nineteenth examples, for any of the sixteenth through seventeenth examples the via opening or the trench is formed within an upper metallization level. The method further comprises forming a lower metallization level below the upper metallization level. Forming the lower metallization level comprises forming at least one of a second via opening or a second trench in a dielectric material, depositing a second barrier material comprising Ta on a surface of the dielectric material, and depositing the fill material over the second barrier material.

In twentieth examples, for any of the sixteenth through nineteenth examples depositing the second barrier material comprises an atomic layer deposition process.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the present disclosure should therefore be determined with reference to the appended claims, along with the full scope of equivalents to which such claims are entitled.

## Claims

1. An integrated circuit (IC) interconnect structure, comprising:
a dielectric material; and
a line or via metallization adjacent to the dielectric material, wherein the line or via metallization comprises:
a fill material comprising a first metal; and
a barrier material between the fill material and the dielectric material, the barrier material having a metal content consisting essentially of Nb.

2. The IC interconnect structure of claim 1, wherein the first metal is Cu, Co, Mo, or W.

3. The IC interconnect structure of any one of claims 1-2, wherein the barrier material is more than 95% pure Nb.

4. The IC interconnect structure of claim 3, wherein barrier material is in direct contact with the dielectric material and wherein the fill material is in direct contact with the barrier material.

5. The IC interconnect structure of any one of claims 1-4, wherein the barrier material has a thickness of no more than 8 nm at a bottom of the line or via metallization.

6. The IC interconnect structure of claim 5, wherein the barrier material has a thickness of at least 3 nm at the bottom of the line or via metallization.

7. The IC interconnect structure of any one of claims 1-6, wherein the IC interconnect structure comprises:
a first line metallization under the dielectric material;
a via metallization through the dielectric material, and coupled to the first line metallization; and
a second line metallization over, and coupled to, the first line metallization through the via metallization, wherein at least the via metallization comprises:
the fill material and the barrier material, the barrier material at a bottom of the via metallization in direct contact with the first line metallization.

8. An integrated circuit (IC) device, comprising:
a plurality of transistors comprising one or more semiconductor materials; and
a plurality of interconnect levels coupled to the plurality of transistors, wherein:
a first of the interconnect levels further comprises a first line or via metallization comprising a first barrier material and a fill material, the first barrier material comprising Ta; and
a second of the interconnect levels further comprises a second line or via metallization comprising a second barrier material and a fill material, the second barrier material comprising Nb.

9. The IC device of claim 8, wherein the first barrier material has a first thickness, less than a second thickness of the second barrier material.

10. The IC device of claim 9, wherein the first thickness is less than 3nm at a bottom of a first via metallization, and the second thickness is at least 3 nm at a bottom of a second via metallization.

11. The IC device of any one of claims 8-10, wherein the second barrier material consists essentially of Nb.

12. The IC device of claim 11, wherein the second barrier material is substantially pure Nb.

13. The IC device of any one of claims 8-12, wherein the first of the interconnect levels is a lower level of interconnect metallization that is over a front side of the transistors and wherein the second of the interconnect levels is an upper level of the interconnect metallization that is over the front side of the transistors.

14. The IC device of any one of claims 8-13, wherein the first of the interconnect levels is over a front side of the transistors, and wherein the second of the interconnect levels is over a back side of the transistors.

15. The IC device of any one of claims 8-14, further comprising a power supply coupled to power the IC device through one or more host components between the power supply and the IC device.
